**Europäisches Patentamt**

**European Patent Office**

**Office européen des brevets**

(19)

(11) Veröffentlichungsnummer : **0 504 674 B1**

(12)

# EUROPÄISCHE PATENTSCHRIFT

(45) Veröffentlichungstag der Patentschrift :
21.06.95 Patentblatt 95/25

(51) Int. Cl.$^6$ : **H01F 38/22**

(21) Anmeldenummer : **92103806.3**

(22) Anmeldetag : **06.03.92**

(54) **Messwandler für elektronische Anordnungen zur schnellen Erkennung von Kurzschlüssen.**

(30) Priorität : **18.03.91 DE 4108802**

(43) Veröffentlichungstag der Anmeldung :
**23.09.92 Patentblatt 92/39**

(45) Bekanntmachung des Hinweises auf die
Patenterteilung :
**21.06.95 Patentblatt 95/25**

(84) Benannte Vertragsstaaten :
**CH DE FR GB IT LI SE**

(56) Entgegenhaltungen :
**EP-A- 0 299 498**
**TRANSDUCERS 85 11. Juni 1985, PHILADEL-**
**PHIA US Seiten 312 - 315 H.KIWAKI ET AL**

(73) Patentinhaber : **VACUUMSCHMELZE GMBH**
**Grüner Weg 37**
**Postfach 2253**
**D-63412 Hanau (DE)**

(72) Erfinder : **Herzer, Giselher, Dr.**
**Humperdinckweg 2**
**W-6450 Hanau 1 (DE)**
Erfinder : **Jelinek, Vladimir, Dipl.-Ing.**
**August-Bebel-Strasse 7**
**W-6458 Rodenbach (DE)**

EP 0 504 674 B1

EP 0 504 674 B1

## Beschreibung

Die Erfindung betrifft einen Meßwandler, der zur Umsetzung eines Stromes bzw. einer Spannung, insbesondere in einer Anordnung mit elektronischen Meß- und Verarbeitungsmitteln, zur schnellen Erkennung von Kurzschlüssen eingesetzt wird.

Eine Anordnung zur schnellen Erkennung von Kurzschlüssen ist beispielsweise aus der EP-A-0 256 341 bekannt. Hierbei werden hohe Ansprüche an die Übertragungseigenschaften der Meßwandler gestellt. Um Kurzschlüsse zuverlässig erkennen zu können, müssen die Meßwandler sowohl Wechselströme (-spannungen) als auch Impulsströme (-spannungen) mit hoher Genauigkeit auf ein für die nachfolgende Elektronik zulässiges Strom- bzw. Spannungsniveau umsetzen. Die Eigenschaften der Meßwandler werden hierbei durch die Eigenschaften der darin verwendeten Magnetkerne und den Wicklungsaufbau bestimmt.

Magnetkerne für Meßwandler sind aus dem Buch von W. Beetz, Meßwandler, Braunschweig, 1958, bekannt. Insbesondere auf den Seiten 19 und 20 sind die Anforderungen an das Material eines solchen Kernes dargelegt. Als vorteilhaft werden Kerne mit hoher Permeabilität und geringen Verlusten angegeben. Neben hochlegiertem Dynamoblech der Art IV (4 % Si), werden Nickel-Eisen-Legierungen wie MUMETALL, PERMALLOY, Carbonylnickeleisen sowie legierte Bleche ohne Nickel genannt. Die magnetischen Eigenschaften der genannten Werkstoffe sind beispielsweise in dem Handbuch der Elektrotechnik der SIEMENS AG, 1971, Seite 174 - 185 angegeben.

Aus der Druckschrift Z017 der Vacuumschmelze GmbH, Ausgabe 10/1980 sind Stromtransformatoren für Regelungs- und Überwachungsaufgaben bekannt. Diese Stromtransformatoren unterscheiden sich - wie dort auch angegeben ist - wesentlich von den klassischen Meßwandlern nach VDE 0414, da die Zuordnung zu Fehlerklassen und die Festlegung des Überstromverhaltens entfällt. Aus dieser Druckschrift sind jedoch die grundsätzlichen Anforderungen an Magnetkernmaterialien abzulesen. Diese Eigenschaften sind abhängig von der Signalform der zu übertragenden Größe. So sollen die Kernmaterialien für Wechselstromanwendung eine hohe Permeabilität und eine runde Hystereseschleife aufweisen. Für Anwendungen bei höheren Frequenzen sind zudem niedrige Ummagnetisierungsverluste erforderlich. Bei Impulsstromtransformatoren, die die Aufgabe haben, impulsförmige Ströme, wie sie beispielsweise in Transistorzerhackern vorkommen, möglichst formgerecht zu übertragen, muß zwischen unipolarer und bipolarer Betriebsweise unterschieden werden. Bei unipolarem Betrieb erfolgt die Magnetisierung zwischen Remanenz und Sättigungsinduktion. Die hierfür verwendeten Magnetmaterialien sollen daher eine niedrige Remanenz, hohen Induktionshub, hohe Impulspermeabilität und bei hohen Folgefrequenzen auch niedrige Ummagnetisierungsverluste aufweisen. Im Gegensatz zu den Wechselstromtransformatoren werden hierfür Werkstoffe mit flacher Hystereseschleife eingesetzt. Für Wechselstrom und Impulsstromtransformatoren werden somit unterschiedliche Magnetkernmaterialien eingesetzt.

Weiterhin ist es bekannt, für Meßwandler amorphe Magnetkerne zu verwenden. In der DE-C-27 08 151 wird die Verwendung einer amorphen Kobalt-Basis-Legierung mit geringer Magnetostriktion und einer Sättigungsinduktion von wenigstens 10 kG für Signalwandler angegeben. Es finden sich dort jedoch keine Hinweise, für welche Strom- bzw. Spannungsformen diese Kerne geeignet sind.

Aus der EP-A1-0 299 498 und EP-A1-0 302355 sind Magnetkerne bekannt, die aus einer feinkristallinen Eisen-Basis-Legierung bestehen. Diese feinkristallinen Legierungen werden durch eine spezielle Wärmebehandlung von rascherstarrten amorphen Legierungsbändern erhalten. Es werden sowohl Pulverkerne als auch Schnittbandkerne und Ringbandkerne angegeben. Als besondere Vorteile werden eine hohe Permeabilität, geringe Sättigungsmagnetostriktion sowie allgemein gute magnetische Eigenschaften bei hohen Frequenzen genannt. Als Anwendungsgebiete werden verschiedene Drosseln, Hochfrequenzübertrager, Motoren und Filter angegeben. Über die spezielle Eignung für Meßwandler finden sich keine Angaben.

Die für Meßwandler bisher eingesetzten Magnetkernmaterialien erlauben es, Meßwandler herzustellen, die für einzelne Strom- bzw. Spannungsformen, wie z. B. Wechsel-, Impuls-, Gleich- oder Differenzstrom (-spannung) geeignet sind.

Aufgabe der Erfindung ist es daher, für Anordnungen zur schnellen Erkennung von Kurzschlüssen Meßwandler anzugeben, die die potentialfreie, amplituden- und phasentreue Umwandlung eines Stromes bzw. einer Spannung in das Eingangssignal einer elektronischen Schaltung ermöglichen, wobei ein gutes Übertragungsverhalten des Wandlers in einem breiten Frequenzbereich (bis zu Frequenzen von 100 kHz und mehr) gesichert sein soll, um ohmsche Kurzschlüsse von induktiven oder kapazitiven Lastzuschaltungen unterscheidbar zu halten. Der Meßwandler muß daher sowohl für die Umwandlung von Wechselströmen (-spannungen) als auch von Spannungs- bzw. Stromimpulsen geeignet sein.

Die Aufgabe wird durch einen Meßwandler mit den Merkmalen des Patentanspruchs 1 gelöst.

Vorteilhafte Ausgestaltungen sind in den Unteransprüchen beschrieben.

Die Erfindung wird im folgenden anhand von Ausführungsbeispielen und der Zeichnungen näher beschrie-

2

ben. Es zeigen:

Fig. 1: die Abhängigkeit der Impulspermeabilität vom Induktionshub für ein geeignetes Magnetkernmaterial;

Fig. 2: die schematische Darstellung eines Stromwandlers

Fig. 3: die Abhängigkeit des Stromfehlers von der Frequenz für einen Stromwandler;

Fig. 4: die Abhängigkeit des Phasenfehlers von der Frequenz für einen Stromwandler;

Fig. 5: die Abhängigkeit des Spannungsfehlers von der Frequenz für einen Spannungswandler;

Fig. 6: die Abhängigkeit des Phasenfehlers von der Frequenz für einen Spannungswandler.

Bei Meßwandlern in Anordnungen zur schnellen Erkennung von Kurzschlüssen werden an die Magnetkernmaterialien und an die Ausgestaltung der Wicklungen hohe Anforderungen gestellt. Die Magnetkernmaterialien müssen zunächst eine hohe Sättigungsinduktion aufweisen, um einen großen Strombereich überstreichen zu können. Für den impulsförmigen Betrieb ist ein hoher unipolarer Induktionshub erforderlich. Um die Übertragungsfehler niedrig zu halten, sind sowohl eine hohe Amplitudenpermeabilität (für Wechselspannungen bzw. -ströme) und auch eine hohe Impulspermeabilität (für Impulsbetrieb) erforderlich. Es hat sich gezeigt, daß bis zu einer Induktion bzw. einem unipolarem Induktionshub von 0,8 T und Frequenzen von 100 kHz eine relative Amplituden- und Impulspermeabilität von mehr als 10 000 erforderlich ist. Die Kerne müssen weiterhin eine flache Magnetisierungsschleife mit einem Remanenzverhältnis von weniger als 0,2 aufweisen. Um den Übertragungsfehler niedrig zu halten, sollte das Magnetkernmaterial weiterhin auch möglichst geringe Kernverluste und eine niedrige Sättigungsmagnetostriktion aufweisen.

Vorzugsweise sollte der Wert der Sättigungsmagnetostriktion unterhalb von $3 . 10^{-6}$ liegen und die Ummagnetisierungsverluste kleiner als 300 mW/g sein.

In den Tabellen 1 bis 3 sind die Amplitudenpermeabilität, die Impulspermeabilität und die Magnetisierungsverluste für verschiedene Magnetkernmaterialien dargestellt. Es handelt sich hierbei um PERMALLOY, die amorphe Eisen-Basislegierung VITROVAC 7505 F mit flacher Magnetisierungsschleife, die amorphe Kobaltbasislegierung VITROVAC 6030F mit flacher Magnetisierungsschleife sowie um eine feinkristalline Legierung FK mit der Zusammensetzung Fe74,5CulNb3Sil6,5B6. Das Gefüge dieser Legierung bestand zu mehr als 50 % aus Körnern mit einer Korngröße von weniger als 50 nm. Die feinkristalline Legierung wurde hergestellt, indem zunächst ein amorphes Band der Legierung mittels der bekannten Raschabschreckung hergestellt wurde und dieses Band anschließend einer Wärmebehandlung zur Erzielung des feinkristallinen Zustandes und der flachen Magnetisierungsschleife unterzogen wurde. Bei der untersuchten Legierung wurden hierzu Wärmebehandlungen von 1 h bei 540 °C und 3 h, 280°C in einem Magnetfeld senkrecht zur Bandrichtung durchgeführt.

Wie die Aufstellung der Werte für die relative Amplitudenpermeabilität in Abhängigkeit von der Frequenz und der Induktionsamplitude in Tabelle 1 zeigt, weist die feinkristalline Legierung eine sehr gute Konstanz der Amplitudenpermeabilität über einen weiten Frequenzbereich auf. Die zum Vergleich angeführten Legierungen zeigen dagegen ein deutlich schlechteres Verhalten. Die Amplitudenpermeabilität von PERMALLOY weist zwar bei der niedrigen Frequenz von 2 kHz sehr hohe Werte auf, fällt jedoch bei hohen Frequenzen sehr stark ab. Die amorphe Legierung VITROVAC 7505F weist zwar insgesamt einen flacheren Verlauf der Amplitudenpermeabilität auf, jedoch sind auch dort die Werte für hohe Frequenzen sehr neidrig. Die Werte von VITROVAC 6030F sind dagegen über den ganzen Frequenzbereich nicht ausreichend.

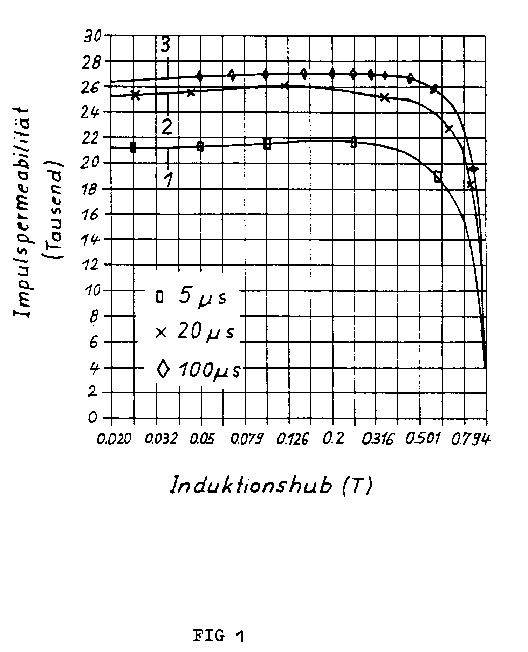

In der Tabelle 2 sind die Werte für die Impulspermeabilität in Abhängigkeit von der Impulsdauer und dem Induktionshub für die gleichen Legierungen zusammengestellt. Auch hier zeigt sich ein gutes Verhalten der feinkristallinen Legierung auch bei kurzen Impulsen von lediglich 5 µs Pulsdauer. Die beiden amorphen Legierungen weisen zwar eine recht gute Konstanz der Werte für die Impulspermeabilität auf, jedoch auf einem zu niedrigen Niveau. Bei PERMALLOY ist dagegen wiederum ein sehr starker Abfall sowohl bei kürzerer Pulsdauer als auch bei höheren Induktionshüben erkennbar. Die Abhängigkeit der Impulspermeabilität vom Induktionshub ist für die feinkristalline Legierung zudem in Fig. 1 dargestellt und zwar in Kurve 1 für eine Impulsdauer von 5 µs in Kurve 2 für eine Impulsdauer von 20 µs und in Kurve 3 für eine Impulsdauer von 100 µs. Die feinkristalline Legierung zeichnet sich durch einen besonders flachen Verlauf der Impulspermeabilität über dem Induktionshub aus. Auch bei einem Induktionshub von 0,8 T beträgt die Impulspermeabilität noch mehr als 10 000.

In Tabelle 3 ist die Abhängigkeit der Ummagnetisierungsverluste von der Induktionsamplitude und der Frequenz dargestellt. Auch hier zeigt die feinkristalline Legierung wiederum die besten Werte. Lediglich die amorphe Legierung VITROVAC 6030F zeigt entsprechend niedrige Werte für die Ummagnetisierungsverluste; jedoch ist diese Legierung wegen der niedrigen Permeabilitätswerte für die Anwendung in Meßwandlern, die in Anordnungen zur Schnellerkennung von Kurzschlüssen eingesetzt werden, ungeeignet.

Neben einem geeigneten Magnetkernmaterial ist zur Erzielung von guten Übertragungseigenschaften bei hohen Frequenzen weiterhin der Wicklungsaufbau von Bedeutung. Zur Reduzierung der Streuinduktivität wurde daher zumindest einer der beiden Leiter als segmentierte Wicklung ausgeführt, wie aus den folgenden Ausführungsbeispielen näher ersichtlich ist.

a) Stromwandler

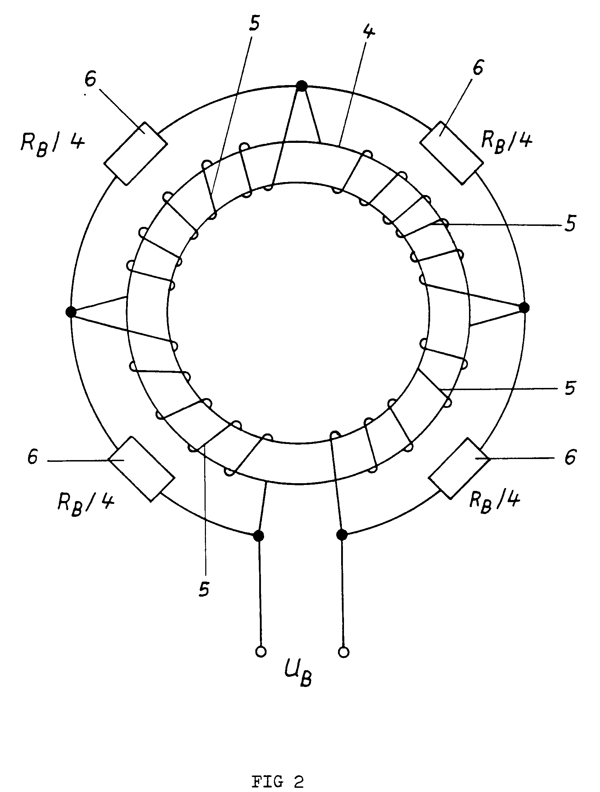

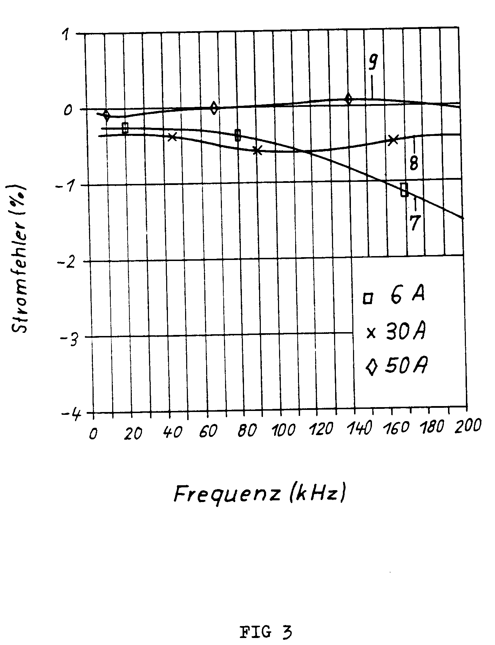

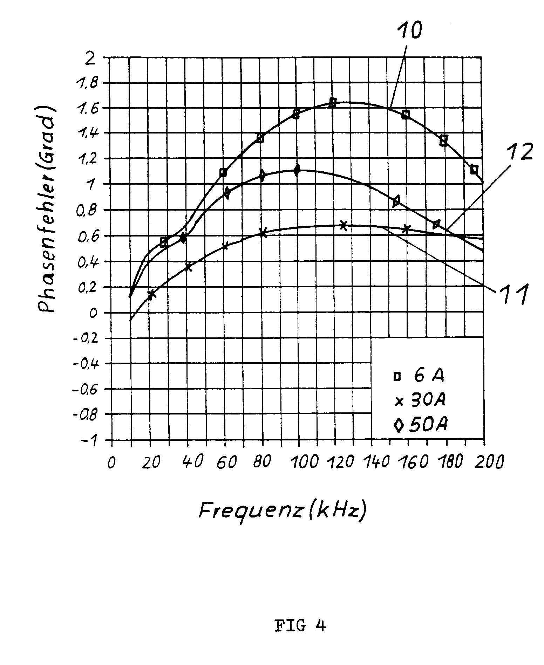

In der Fig. 2 ist der Aufbau eines als Durchsteckwandler konstruierten Stromwandlers ohne den primären Leiter schematisch dargestellt. Der Wandler weist einen Ringkern 4 aus der bereits angegebenen feinkristallinen Legierung auf. Die Eisenweglänge des Ringkernes beträgt etwa 16,8 cm, der Eisenquerschnitt etwa 0,14 cm². Auf den Kern ist die Sekundärwicklung aufgebracht, die aus vier Teilwicklungen 5 besteht. Im Ausführungsbeispiel wies jede der Teilwicklungen 250 Windungen auf. Die vier Segmente waren in Reihe geschaltet und jedes Segment durch einen Bürdenwiderstand von 1,25 Ohm abgeschlossen. An dem Stromwandler wurden sowohl der Stromfehler als auch der Phasenfehler gemessen. Der Stromfehler gibt die Abweichung der sekundären Meßgröße vom Sollwert an, der Phasenfehler kennzeichnet die Phasenverschiebung zwischen der primären und der sekundären Meßgröße. Die Abhängigkeit des Stromfehlers von der Frequenz ist in Fig. 3 dargestellt. Kurve 7 zeigt den Verlauf des Stromfehlers für einen Strom von 6 Ampere, Kurve 8 für einen Strom von 30 Ampere und Kurve 9 für einen Strom von 50 Ampere. In Fig. 4 ist die Abhängigkeit des Phasenfehlers von der Frequenz dargestellt und zwar wiederum für einen Primärstrom von 6 Ampere (Kurve 10), 30 Ampere (Kurve 11) und 50 Ampere (Kurve 12).

b) Spannungswandler

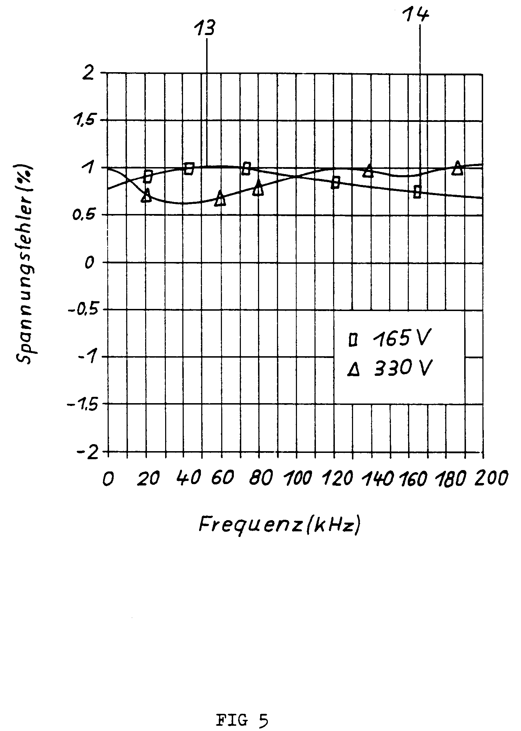

Auch bei dem Spannungswandler wurde - um auch bei hohen Frequenzen gute Übertragungseigenschaften zu erzielen - eine Segmentierung der Wicklung vorgenommen, um die Streuinduktivität zu verringern. Der Spannungswandler weist auf der Primärseite eine Gesamtwindungszahl von 1100 auf. Die primärseitige Wicklung wurde in vier Segmente aufgeteilt, die in Reihe zusammengeschaltet sind. Als besonders vorteilhaft hat es sich herausgestellt, wenn auch die Wicklung der Sekundärseite segmentiert wird. Hierzu wurden über jedes Segment der Primärseite fünf Windungen gewickelt, die untereinander parallel geschaltet sind. Der Spannungswandler weist ebenfalls einen Kern aus der bereits angegebenen feinkristallinen Legierung auf. Die Eisenweglänge beträgt etwa 18,4 cm und der Eisenquerschnitt 1 cm². An dem Spannungswandler wurden der Spannungsfehler, der die Abweichung der Sekundärspannung vom Sollwert angibt und der Phasenfehler gemessen. Der Spannungsfehler ist in Abhängigkeit von der Frequenz in Fig. 5 dargestellt und zwar für eine Spannung von 165 Volt in Kurve 13 und für eine Spannung von 330 Volt in Kurve 14.

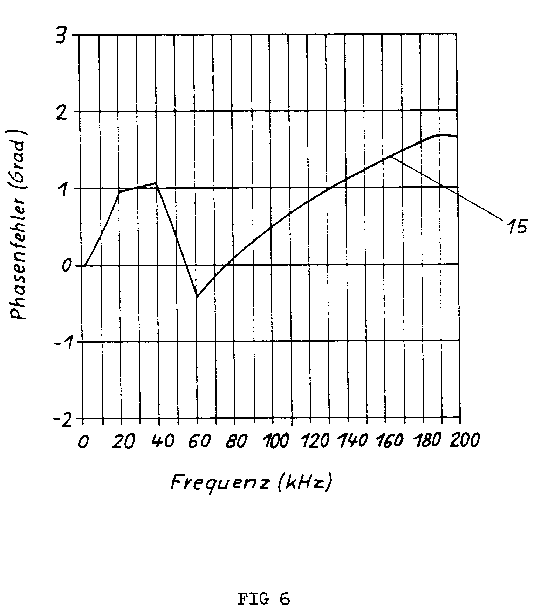

In Fig. 6 ist die Abhängigkeit des Phasenfehlers von der Frequenz als Kurve 15 aufgetragen. Die Messungen wurden bei Spannungen zwischen 165 Volt und 330 Volt durchgeführt. Eine signifikante Abhängigkeit des Phasenfehlers von der Spannung konnte in diesem Spannungsbereich nicht festgestellt werden.

Die erfindungsgemäßen Meßwandler sind sowohl zur Übertragung von Wechselströmen (-spannungen) als auch von Impulsströmen (-spannungen) geeignet und ermöglichen somit eine weitere Verbesserung in Anordnungen zur Schnellerkennung von Kurzschlüssen, so daß von den Meßwandlern her nunmehr die Möglichkeit gegeben ist, Kurzschlüsse schon im Entstehen zu erkennen. Die Wandler gestatten die potentialfreie amplituden- und phasentreue Umwandlung sowohl eines stationären als auch eines transienten Stromes (bzw. -spannung) und weisen auch bei hohen Werten der Frequenz, der Induktion und des Induktionshubes gute Übertragungseigenschaften auf.

T a b e l l e  1

|  | | Amplitudenpermeabilität | | | |
|  | | | V I T R O V A C | | |
| f | $\hat{B}$ | PERMALLOY | 7505F | 6030F | FK |
| --- | --- | --- | --- | --- | --- |
|  | 0,01 | 39100 | 8790 | 2790 | 22800 |
|  | 0,1 | 47800 | 13600 | 2880 | 31200 |
| 2 kHz | 0,5 | 81400 | 12400 | 2840 | 32900 |
|  | 0,8 | 10010 | 10100 | 2650 | 29600 |
|  | 0,01 | 2690 | 4450 | 2600 | 12900 |
|  | 0,1 | 4080 | 5230 | 2530 | 13500 |
| 200 kHz | 0,2 | -- | -- | -- | 13500 |

T a b e l l e  2

|  | | Impulspermeabilität | | | |
|  | | | V I T R O V A C | | |
| $t_d$ | $\Delta B$ | PERMALLOY | 7505F | 6030F | FK |
| --- | --- | --- | --- | --- | --- |
|  | 0,01 | 26900 | 7550 | 2570 | 26100 |
|  | 0,1 | 22500 | 8590 | 2750 | 26900 |
| 100 µs | 0,3 | 3450 | 8070 | 2810 | 27000 |
|  | 0,8 | - | 6620 | - | 22500 |
|  | 0,01 | 7800 | 6300 | 2570 | 21300 |
|  | 0,1 | 6380 | 7120 | 2740 | 21700 |
| 5 µs | 0,3 | 1360 | 5620 | 2760 | 21600 |
|  | 0,8 | - | - | - | 15400 |

T a b e l l e  3

|  | | Ummagnetisierungsverluste (mW/g) | | | |
|  | | | V I T R O V A C | | |
| f | $\hat{B}(T)$ | PERMALLOY | 7505F | 6030F | FK |
| --- | --- | --- | --- | --- | --- |
|  | 0,05 | 0,081 | 0,0952 | 0,0228 | 0,0149 |
|  | 0,1 | 0,338 | 0,507 | 0,111 | 0,0709 |
| 5 kHz | 0,3 | 2,88 | 5,52 | 0,764 | 0,950 |
|  | 0,05 | 4,26 | 2,06 | 0,799 | 0,771 |
|  | 0,1 | 16,2 | 8,52 | 3,41 | 3,16 |
| 50 kHz | 0,3 | 131 | 133 | 32,7 | 29,5 |

**Patentansprüche**

1.  Meßwandler, der zur Umsetzung eines Stromes bzw. einer Spannung, insbesondere in einer Anordnung mit elektronischen Meß- und Verarbeitungsmitteln, zur schnellen Erkennung von Kurzschlüssen eingesetzt wird, mit primär- und sekundärseitigen Leitern, wobei zumindest einer der Leiter als segmentierte Wicklung ausgeführt ist, und mit einem weichmagnetischen Kern mit einem Remanenzverhältnis von weniger als 0,2, der bis zu einer Induktion bzw. einem unipolaren Induktionshub von 0,8 T und bis zu Frequenzen von 100 kHz eine relative Amplituden- und Impulspermeabilität von mehr als 10 000 aufweist, wobei als Magnetkernmaterial eine magnetostriktionsarme Legierung verwendet wird, die neben Eisen und üblichen Verunreinigungen 0,1 - 3 Atom-% Cu, 0,1 - 30 Atom-% weitere Metalle wie Nb, W, Ta, Zr, Hf, Ti, V, Cr oder Mo, bis zu 30 Atom-% Si und bis zu 25 Atom-% B, bei einem Gesamtgehalt an Si und B zwischen 5 und 30 Atom-%, enthält und deren Gefüge zu mehr als 50 % aus feinkristallinen Körnern mit einer Korngröße von weniger als 50 nm besteht.

2.  Meßwandler nach Anspruch 1, **dadurch gekennzeichnet**, daß das Magnetkernmaterial eine Sättigungsmagnetostriktion von weniger als $3.10^{-6}$ aufweist.

3.  Meßwandler nach Anspruch 1, **dadurch gekennzeichnet**, daß das Magnetkernmaterial Ummagnetisierungsverluste von weniger als 300 mW/g aufweist.

4.  Meßwandler nach Anspruch 1, **dadurch gekennzeichnet**, daß er als Stromwandler eingesetzt wird und der sekundärseitige Leiter als segmentierte, jeweils durch Teilbürdenwiderstände abgeschlossene Wicklung ausgebildet ist.

5.  Meßwandler nach Anspruch 4, **dadurch gekennzeichnet**, daß es sich um einen Durchsteckstromwandler handelt.

6.  Meßwandler nach Anspruch 1, **dadurch gekennzeichnet**, daß er als Spannungswandler eingesetzt wird und der primärseitige Leiter als segmentierte Wicklung ausgebildet ist.

7.  Meßwandler nach Anspruch 6, **dadurch gekennzeichnet**, daß der sekundärseitige Leiter aus parallel geschalteten Teilwicklungen besteht, die jeweils über ein primärseitiges Wicklungssegment gewickelt sind.


**Claims**

1.  Measuring transformer which is used to transform a current or a voltage, in particular in an arrangement with electronic measuring and processing means, for rapid recognition of short circuits, with primary and secondary conductors, at least one of the conductors taking the form of a segmented winding, and with a soft magnetic core with a remanence ratio of less than 0.2, which exhibits a relative amplitude and pulse permeability of more than 10,000 up to an induction or a unipolar induction deviation of 0.8 T and up to frequencies of 100 kHz, the material used for the magnet core being a low-magnetostriction alloy which, in addition to iron and usual impurities, contains 0.1 - 3 gram-atomic % of Cu, 0.1 - 30 gram-atomic % of further metals such as Nb, W, Ta, Zr, Hf, Ti, V, Cr or Mo, up to 30 gram-atomic % of Si and up to 25 gram-atomic % of B, with a total content of Si and B of between 5 and 30 gram-atomic %, and more than 50% of the structure of which consists of fine crystalline grains with a grain size of less than 50 nm.

2.  Measuring transformer according to claim 1, characterised in that the magnet core material exhibits a saturation magnetostriction of less than $3.10^{-6}$.

3.  Measuring transformer according to claim 1, characterised in that the magnet core material exhibits remagnetisation losses of less than 300 nW/g.

4.  Measuring transformer according to claim 1, characterised in that it is used as a current transformer and the secondary conductor takes the form of a segmented winding terminated in each case by partial load resistors.

5.  Measuring transformer according to claim 4, characterised in that it is a bushing current transformer.

6. Measuring transformer according to claim 1, characterised in that it is used as a voltage transformer and the primary conductor takes the form of a segmented winding.

7. Measuring transformer according to claim 6, characterised in that the secondary conductor consists of partial windings which are connected in parallel and in each case wound over a primary winding segment.

**Revendications**

1. Transformateur de mesure utilisé pour la conversion d'une intensité ou d'une tension, en particulier dans un dispositif ayant des moyens de mesure et de traitement électroniques, destiné à détecter rapidement des courts-circuits, ayant des conducteurs du côté primaire et du côté secondaire, l'un des conducteurs au moins étant réalisé en enroulement segmenté, ayant un noyau magnétique doux avec un rapport de rémanence inférieur à 0,2, qui comporte, jusqu'à une induction ou une amplitude d'induction unipolaire de 0,8 T et jusqu'à des fréquences de 100 kHz, une perméabilité d'amplitude et d'impulsions relative supérieure à 10 000, un alliage à faible magnétostriction étant utilisé comme matériau de noyau magnétique, qui contient, à côté du fer et d'autres impuretés, 0,1-3 % d'atomes de Cu, 0,1 à 30 % d'atomes d'autres métaux comme Nb, W, Ta, Zr, Hf, Ti, V, Cr ou Mo, jusqu'à 30 % d'atomes de Si et jusqu'à 25 % d'atomes de B, pour une teneur totale en Si et B comprise entre 5 et 30 % d'atomes, et sa structure étant composée de plus de 50 % de grains finement cristallins ayant une taille de grains inférieure à 50 nm.

2. Transformateur de mesure selon la revendication 1, caractérisé en ce que le matériau du noyau magnétique présente une magnétostriction de saturation inférieure à $3.10^{-6}$.

3. Transformateur de mesure selon la revendication 1, caractérisé en ce que le matériau de noyau magnétique a des pertes par inversion magnétique inférieures à 300 mW/g.

4. Transformateur de mesure selon la revendication 1, caractérisé en ce qu'il est mis en oeuvre comme transformateur d'intensité et en ce que le conducteur du côté secondaire est réalisé en enroulement segmenté, respectivement séparé par des résistances de charge partielles.

5. Transformateur de mesure selon la revendication 4, caractérisé en ce qu'il s'agit d'un transformateur à courant traversant.

6. Transformateur de mesure selon la revendication 1, caractérisé en ce qu'il est utilisé comme transformateur de tension, et en ce que le conducteur du côté primaire est réalisé en enroulement segmenté.

7. Transformateur de mesure selon la revendication 1, caractérisé en ce que le conducteur du côté secondaire se compose d'enroulements partiels montés en parallèle, qui sont enroulés respectivement sur un segment d'enroulement du côté primaire.

FIG 1

FIG 2

FIG 3

FIG 4

FIG 5

FIG 6